# EUROPEAN PATENT APPLICATION

(11) **EP 4 607 577 A1**
(43) Date of publication of application: **27.08.2025**
(21) Application number: 25158227.6
(22) Date of filing: 17.02.2025
(51) Int. Cl.: H01L 21/67, H01L 21/677, H01L 21/683

(54) **SUBSTRATE PROCESSING APPARATUS**

(30) Priority: 20.02.2024 KR 20240024588
(71) Applicant: Hanwha Solutions Corporation, Jung-gu Seoul 04541 (KR)
(72) Inventor: KU, Chan Hoe, 04541 Seoul (KR); LEE, Kwang Youn, 04541 Seoul (KR); CHO, Sang Hyun, 04541 Seoul (KR)
(74) Representative: Mooser, Sebastian Thomas

(57) **Abstract**

The present invention relates to a substrate processing apparatus in which a material adsorbed onto a tray undergoes a process. One embodiment of the present invention provides a substrate processing apparatus including a tray having an adsorption maintenance space formed therein, a driving unit configured to allow the tray to successively pass through a plurality of process sections, a low pressure forming unit positioned at one side of the driving unit at a position before the tray enters the plurality of process sections and configured to discharge a fluid from the adsorption maintenance space to form a pressure difference between the adsorption maintenance space and the outside, and a pressure difference removing unit disposed at one side of the driving unit at a position at which all of the plurality of process sections end and configured to inject a fluid into the adsorption maintenance space, wherein the tray adsorbs a material using the pressure difference.

## Description

### BACKGROUND

### 1. Field of the Invention

The present invention relates to a substrate processing apparatus, and more specifically, to a substrate processing apparatus in which a material adsorbed onto a tray undergoes a process.

### 2. Discussion of Related Art

A substrate processing apparatus is an apparatus in which a material used in product manufacturing is loaded and passes through at least one product manufacturing process to cause the material to undergo the process. There are various methods of transferring a material in a substrate processing apparatus. A tray may be moved in a state in which a material is simply placed on the tray, or a material may be moved while fixed with a fixing member such as a chuck. Alternatively, a material may be adsorbed onto a tray and the tray may be moved.

Among these, transfer through adsorption is widely used because it takes relatively little time to attach or detach a material and is more stable than simple placement. However, somewhat complex equipment is required to maintain a state in which a material is adsorbed onto a tray.

Meanwhile, when a material undergoes a plurality of processes, it is necessary to set a material movement speed required for each process differently according to the characteristics of each process. However, existing methods of transferring materials using belts or rollers have a problem in that it is difficult to set a material movement speed differently for each process.

The information in the background art described above was obtained by the inventors for the purpose of developing the present disclosure or was obtained during the process of developing the present disclosure. As such, it is to be appreciated that this information did not necessarily belong to the public domain before the patent filing date of the present disclosure.

### SUMMARY OF THE INVENTION

The present invention is directed to providing a substrate processing apparatus that maintains an adsorption state of a material using a tray having an adsorption maintenance space and includes a driving unit capable of setting a movement speed of the material differently for each process.

However, the objects are exemplary, and the objects to be solved by the present invention are not limited thereto. Objects which are not described herein should be clearly understood by those skilled in the art from the following detailed description and the accompanying drawings.

According to an aspect of the present invention, there is provided a substrate processing apparatus including a tray having an adsorption maintenance space formed therein, a driving unit configured to allow the tray to successively pass through a plurality of process sections, a low pressure forming unit positioned at one side of the driving unit at a position before the tray enters the plurality of process sections and configured to discharge a fluid from the adsorption maintenance space to form a pressure difference between the adsorption maintenance space and the outside, and a pressure difference removing unit disposed at one side of the driving unit at a position at which all of the plurality of process sections end and configured to inject a fluid into the adsorption maintenance space, wherein the tray adsorbs a material using the pressure difference.

The material may move through each of the plurality of process sections for a movement time set for each of the plurality of process sections, and the movement times may all be different or some may be equal among the plurality of process sections.

A movement speed at which the driving unit moves the tray may be different for each of the plurality of process sections.

The tray may further include a support on which the material is placed, the support may include an adsorption surface which is in in contact with one surface of the material to adsorb the material, and an area of the adsorption surface may be smaller than that of the one surface of the material with which the adsorption surface is in contact.

The tray may further include at least one adsorption hole formed in the adsorption surface and connected to the adsorption maintenance space, a flow path entrance that closes when separated from the low pressure forming unit and the pressure difference removing unit, and a connection flow path configured to connect the adsorption maintenance space and the flow path entrance.

The tray may further include an adsorption groove formed in the adsorption surface and extending from the adsorption hole.

The support may further include an adsorption auxiliary member, and the adsorption auxiliary member may include a second adsorption hole which is formed in an area corresponding to the adsorption hole and communicates with the adsorption hole.

The tray may further include a plurality of through-holes through which a plurality of lift pins configured to lift the material pass, and the through-holes may be spaced apart from the adsorption maintenance space.

The low pressure forming unit may include a plurality of low pressure forming units, and each of the plurality of low pressure forming units may be positioned at a position before the tray enters one of the plurality of process sections.

The pressure difference formed by some or all of the plurality of low-pressure forming units may be different.

The plurality of process sections may include a first process section in which a plasma treatment process is performed on the material, a second process section in which a rinse process is performed on the material, a third process section in which a first drying process is performed on the material, a fourth process section in which a coating process is performed on the material, and a fifth process section in which a second drying process is performed on the material, wherein the coating process includes a process of coating the material with a self-assembled monolayer (SAM) material.

Aspects, features, and advantages other than those described above will become apparent from the following detailed description, claims and drawings for embodying the present invention.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a perspective view illustrating a substrate processing apparatus according to one embodiment of the present invention;
FIG. 2 is a front view illustrating the substrate processing apparatus according to one embodiment of the present invention;
FIG. 3 is a plan view illustrating the substrate processing apparatus according to one embodiment of the present invention;
FIG. 4 is a cross-sectional view along line I-I' of FIG. 3 and illustrates a tray according to one embodiment of the present invention;
FIG. 5 is a view illustrating a difference in size between a material to be transferred by the substrate processing apparatus according to one embodiment of the present invention and an adsorption surface according to one embodiment of the present invention;
FIG. 6 is a view illustrating a portion of the tray according to one embodiment of the present invention;
FIG. 7 is a view illustrating a tray including an adsorption auxiliary member according to one embodiment of the present invention;
FIG. 8 shows a view illustrating a portion of a tray and a cross-sectional view along line II-II' according to another embodiment of the present invention;
FIG. 9 is a view illustrating a portion of a tray according to still another embodiment of the present invention;
FIG. 10 shows views illustrating a process of separating a material from the tray in sequence through a cross section of the tray along line III-III' of FIG. 9;
FIG. 11 is a plan view illustrating a substrate processing apparatus according to another embodiment of the present invention; and
FIG. 12 is a diagram illustrating a movement speed and a pressure difference according to a position of a material in the substrate processing apparatus according to another embodiment of the present invention.

### DETAILED DESCRIPTION OF EXEMPLARY EMBODIMENTS

Since the present invention can apply various transformations and have various embodiments, specific embodiments will be illustrated in the accompanying drawings and described in detail in the detailed description. However, it should be understood that this is not intended to limit the present invention to specific embodiments, and all transformations, equivalents, and substitutions included in the spirit and scope of the present invention are included. In the description of the present invention, even when illustrated in other embodiments, like reference numerals refer to like components.

Hereinafter, embodiments of the present invention will be described in detail with reference to the accompanying drawings, wherein like reference numerals refer to the same or corresponding components throughout the drawings, and redundant description thereof will be omitted.

In the following embodiments, the terms "first," "second," and the like do not have limiting meanings but are used for the purpose of distinguishing one component from another component.

In the following embodiments, the expressions used in the singular such as "a" and "an" are intended to include the plural forms as well, unless the context clearly indicates otherwise.

In the following embodiments, it will be understood that terms such as "including," "comprising," and "having" specify the presence of stated features or components, but do not preclude the presence or addition of one or more other features or components.

In the drawings, components may be exaggerated or reduced in size for convenience of description. For example, the sizes and thicknesses of the respective components shown in the drawings are arbitrarily shown for convenience of description, and thus the present invention is not necessarily limited thereto.

In the following embodiments, an X-axis, a Y-axis, and a Z-axis are not limited to three axes in an orthogonal coordinate system and may be interpreted in a broad sense that includes the three axes. For example, the X-axis, Y-axis, and Z-axis may be orthogonal to each other, or may be oriented in different directions that are not orthogonal to each other.

When a certain embodiment may be implemented differently, a specific process order may be performed differently from the described order. For example, two consecutively described processes may be performed substantially at the same time or may be performed in an order opposite to the described order.

The terms used herein are merely used to describe specific embodiments and are not intended to limit the disclosure. In the present application, the word "comprise" or "have" is used to specify the existence of a feature, a number, a process, an operation, a constituent element, a part, or a combination thereof, and it will be understood that the existence or additional possibility of one or more other features, numbers, processes, operations, constituent elements, parts, or combinations thereof are not excluded in advance.

In the following embodiments, it will be understood that when an element such as a layer, film, region, or substrate is referred to as being connected to another element, it can be directly connected to the other element or intervening elements may also be present. For example, in the present specification it will be understood that when an element such as a layer, film, region, or substrate is referred to as being electrically connected to another element, it can be electrically connected directly to the other element or intervening elements may also be present.

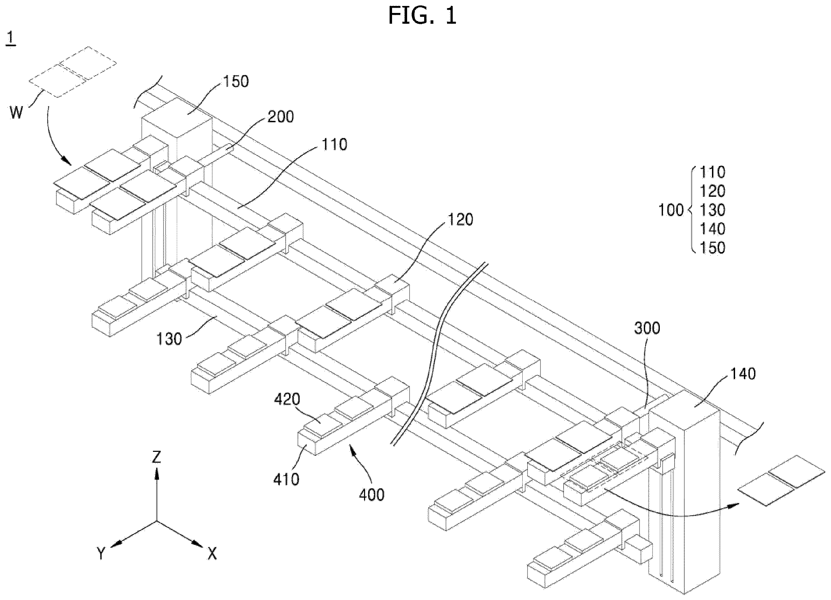

Hereinafter, a substrate processing apparatus according to an embodiment of the present invention will be described with reference to FIGS. 1 to 12.

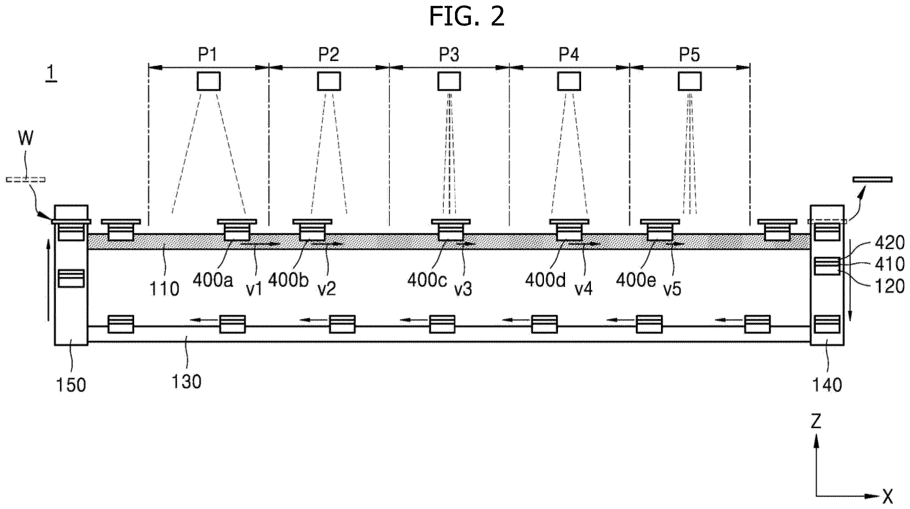

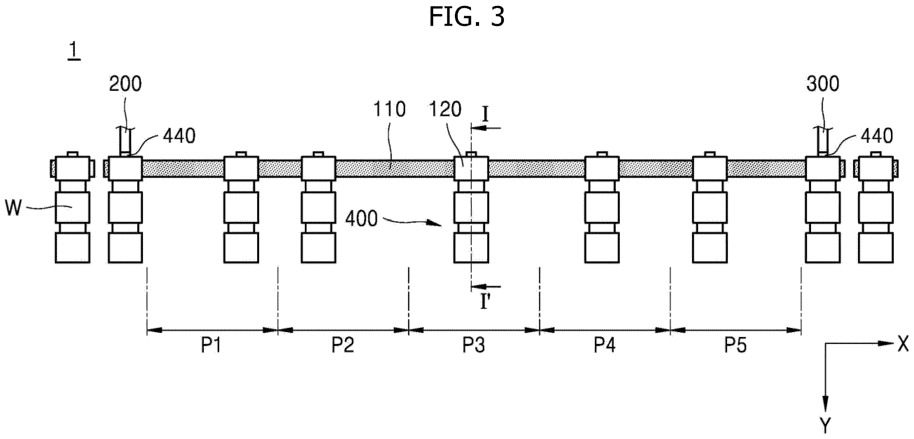

FIG. 1 is a perspective view illustrating a substrate processing apparatus 1 according to one embodiment of the present invention. FIG. 2 is a front view illustrating the substrate processing apparatus 1 according to one embodiment of the present invention. FIG. 3 is a plan view illustrating the substrate processing apparatus 1 according to one embodiment of the present invention.

The substrate processing apparatus 1 is an apparatus in which a material W used in product production is loaded and passes through a plurality of product manufacturing processes to cause the material W to undergo a plurality of processes. A type of a product manufactured by the substrate processing apparatus 1 is not particularly limited. In one embodiment, the product may include a semiconductor or a solar cell. The material W that is a transfer target of the substrate processing apparatus 1 is likewise not particularly limited. In one embodiment, the material W may include a substrate (wafer). Referring to FIG. 1, the substrate processing apparatus 1 may include a driving unit 100, a low pressure forming unit 200, a pressure difference removing unit 300, and a tray 400.

The driving unit 100 may allow the tray 400 to be described below to sequentially pass through a plurality of process sections P. The plurality of process sections P are sections in which a set of processes that should be sequentially performed on the material W are performed. For example, referring to FIG. 2, the plurality of process sections P may include a first process section P1, a second process section P2, a third process section P3, a fourth process section P4, and a fifth process section P5. However, this is merely an example for describing the present invention, and the present invention is not limited thereto. That is, the number of processes included in the plurality of process sections P is not particularly limited.

The driving unit 100 may include a guide block 110, a transfer block 120, a return guide block 130, a lowering block 140, and a lifting block 150.

The guide block 110 may sequentially pass through the plurality of process sections P and may guide a movement path of the tray 400. That is, the guide block 110 may be disposed parallel to an arrangement direction of the plurality of process sections P. For example, referring to FIG. 2, the plurality of process sections P may be arranged in an X-axis direction. In this case, the guide block 110 may extend parallel to the X-axis.

The transfer block 120 may be connected to an upper end of the guide block 110 to move along the guide block 110. Referring to FIGS. 1 and 3, the tray 400 to be described below may be fixed to one end of the transfer block 120. That is, the tray 400 may be fixed to the transfer block 120 and moved along the guide block 110 by the transfer block 120.

The material W may move for a set movement time in one process section P and move to a subsequent process section P. Specifically, the material W may move between a start point and an end point (a start point of a subsequent process section P) of one process section P for a set movement time. That is, the material W may be moved through each of the plurality of process sections P, and a process may be performed for a set movement time. That is, a movement time may be considered as a process time in each process. For example, the process times in the plurality of process sections P may be different, and the process times in some process sections P may be equal to each other.

A movement speed v at which the driving unit 100 moves the tray 400 may be different for each of the plurality of process sections P. Since the tray 400 is fixed to the transfer block 120, the movement speed v of the tray 400 is a movement speed of the transfer block 120. Each tray 400 may have different movement speeds v at the same time. In addition, the movement speed v of one tray 400 may be changed according to a current moment position. Since speed control is possible for each process section P, there is no need to secure a transfer distance for speed compensation for each process, and a size of equipment can be reduced.

For a specific example, as shown in FIG. 2, a first movement speed v1 of a first tray 400a, a second movement speed v2 of a second tray 400B, a third movement speed v3 of a third tray 400C, a fourth movement speed v4 of a fourth tray 400d, and a fifth movement speed v5 of a fifth tray 400e may all be different at the same time. In addition, the movement speed v of one tray 400 may be the first movement speed v1 in the first process section P1, may be changed to the second movement speed v2 in the second process section P2, may be changed to the third movement speed v3 in the third process section P3, may be changed to the fourth movement speed v4 in the fourth process section P4, and may be changed to the fifth movement speed v5 in the fifth process section P5.

In one embodiment, the guide block 110 and the transfer block 120 may each include a linear motion system (LMS). That is, the guide block 110 may include an electromagnet of which magnetic strength is changed according to a change in current. The transfer block 120 may include a permanent magnet. By controlling a current of the electromagnet included in a portion of the guide block 110 with which the transfer block 120 is in contact, the movement speed v of the tray 400 may be set differently for each transfer block 120. However, this is merely an example, and a principle behind changing the movement speed v of the tray 400 for each of the plurality of process sections P is not limited thereto.

In another embodiment, the movement speed v of the tray 400 may be the same in all of the process sections P, and lengths of the process sections P may be different. Accordingly, there is no need to control a speed of the tray 400 according to the process section P, and thereby the number of components such as a driving unit and a control unit for controlling the speed of the tray 400 can be minimized.

For a specific example, although not shown in the drawings, lengths of the first to fifth process sections P1 to P5 may all be different, or lengths of some process sections P may be equal to each other. The first process section P1 may have a first length, the second process section P2 may have a second length, the third process section P3 may have a third length, the fourth process section P4 may have a fourth length, and the fifth process section P5 may have a fifth length. In this case, the first to fifth lengths may be different. In addition, some of the first to fifth lengths may be equal to each other, and others may be different. Here, the length of the process section is a length of the tray 400 in a process passage direction (X-axis).

The return guide block 130 may move the tray 400, which has passed through all of the plurality of process sections P, back to an initial position of the plurality of process sections P. The return guide block 130 may be parallel to the guide block 110 at a lower end of the guide block 110. The movement speed of the tray 400 on the return guide block 130 is not particularly limited.

Referring to FIGS. 1 and 2, the lowering block 140 may move the tray 400, which has passed through the plurality of process sections P, from the guide block 110 to the return guide block 130. In one embodiment, in a state in which the transfer block 120 is coupled onto an auxiliary block having the same cross section as the guide block 110 and the return guide block 130, the lowering block 140 may be moved in such a manner that the auxiliary block moves along a rail disposed on the lowering block 140 in a Z-axis direction. However, a method in which the lowering block 140 moves the tray 400 is not limited thereto.

Referring to FIGS. 1 and 2, the lifting block 150 may move the tray 400 moved along the return guide block 130 to the guide block 110. A moving direction of the tray 400 on the lifting block 150 may be opposite to a moving direction of the tray 400 on the lowering block 140. A principle of movement of the tray 400 on the lifting block 150 may be the same as or similar to the above-described principle of movement of the tray 400 on the lowering block 140.

Since the driving unit 100 includes the return guide block 130, the lowering block 140, and the lifting block 150, a limited number of trays 400 can be used repeatedly, and a size of equipment can be reduced, which is economical.

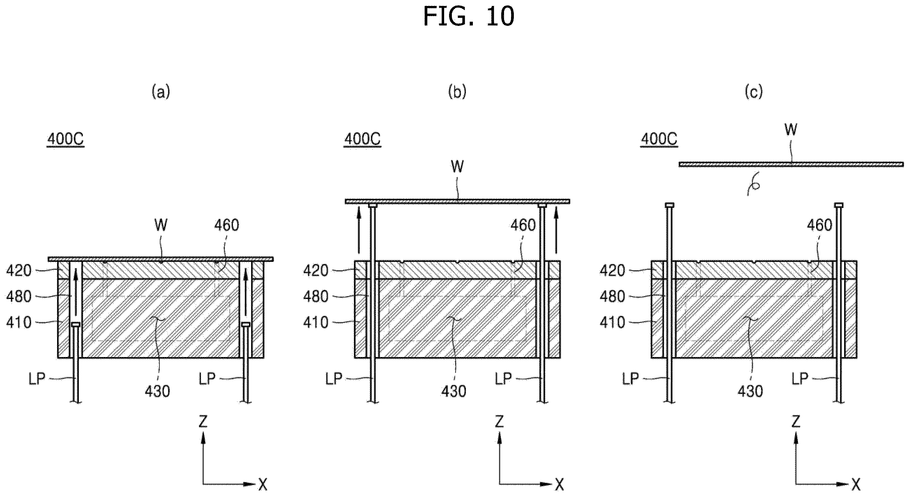

The tray 400 may be circulated by the driving unit 100. Referring to FIGS. 1 to 3, describing the overall circulation flow, the material W may be placed on the tray 400 just before the tray 400 enters the guide block 110 or before the plurality of process sections P start. The tray 400 on which the material W is placed may move along the guide block 110 to pass through the plurality of process sections P. After passing through all of the plurality of process sections P, the material W may be lifted from the tray 400 and moved to a subsequent process. In this case, in one embodiment, the material W may be lifted from the tray 400 by a lift pin LP (see FIG. 10). The tray 400 separated from the material W may sequentially pass the lowering block 140, the return guide block 130, and the lifting block 150 to return to a position before the plurality of process sections P start.

The low pressure forming unit 200 may form a low pressure inside the tray 400 such that the material W is adsorbed onto the tray 400. Specifically, the low pressure forming unit 200 may discharge a fluid from an adsorption maintenance space 430 to be described below to form a pressure difference ΔP between the adsorption maintenance space 430 and the outside. The fluid may fill the adsorption maintenance space 430 and may serve as a medium that changes the pressure of the adsorption maintenance space 430. In one embodiment, the fluid may include air.

Referring to FIG. 3, the low pressure forming unit 200 may be positioned at one side of the driving unit 100 at a position before the tray 400 enters the plurality of process sections P. The low pressure forming unit 200 may may be coupled to a flow path entrance 440 to be described below and connected to the adsorption maintenance space 430.

In one embodiment, with respect to the guide block 110, the low pressure forming unit 200 may be disposed in a direction opposite to a space to which the material W moves. That is, referring to FIG. 3, with respect to the guide block 110 extending in the X-axis direction, the low pressure forming unit 200 may be disposed in a direction opposite to a space (Y-axis direction) to which the material W moves. Accordingly, the low pressure forming unit 200 can be prevented from interfering with or interrupting the movement of the material W, and an arrangement design between components can be simplified.

The pressure difference removing unit 300 may serve to remove the pressure difference ΔP between the inside and the outside of the tray 400 such that the material W may be separated from the tray 400 and a state in which the material W is adsorbed onto the tray 400 may be terminated. Specifically, the pressure difference removing unit 300 may remove the pressure difference ΔP between the adsorption maintenance space 430 and the outside by injecting a fluid into the adsorption maintenance space 430. The pressure difference removing unit 300 may be coupled to the flow path entrance 440 to be described below and connected to the adsorption maintenance space 430.

Referring to FIG. 3, the pressure difference removing unit 300 may be disposed at one side of the driving unit 100 at a position at which the plurality of process sections P all end. Accordingly, the material W that has passed through all of the plurality of process sections P may be lifted by the lift pin LP.

In one embodiment, the pressure difference removing unit 300 may be disposed in the same direction as the low pressure forming unit 200 with respect to the guide block 110. In other words, with respect to the guide block 110, the pressure difference removing unit 300 may be disposed in a direction opposite to a space to which the material W moves. Such an effect is identical or similar to that described for the low pressure forming unit 200 and thus is omitted.

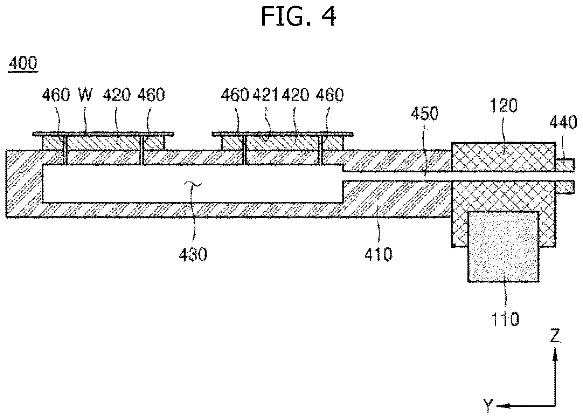

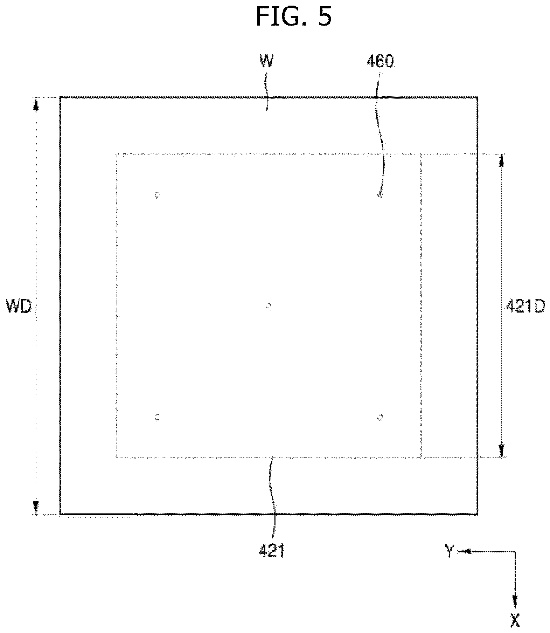

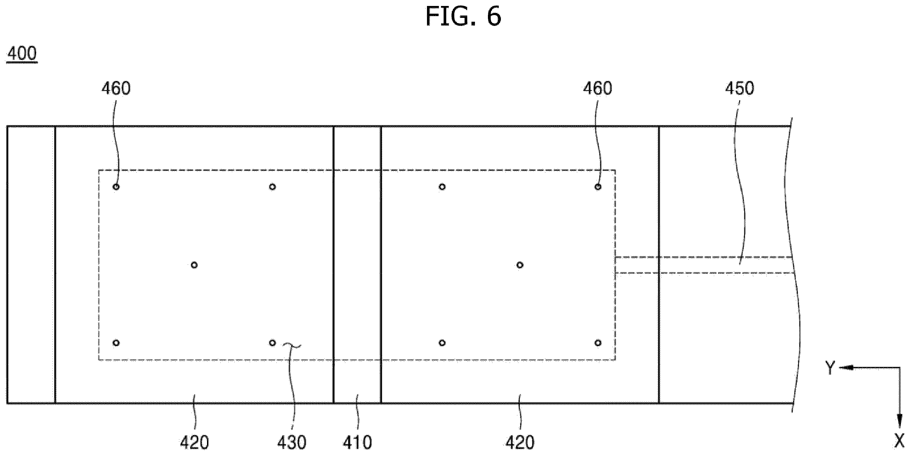

FIG. 4 is a cross-sectional view along line I-I' of FIG. 3 and illustrates the tray 400 according to one embodiment of the present invention. FIG. 5 is a view illustrating a difference in size between the material W to be transferred by the substrate processing apparatus 1 according to one embodiment of the present invention and an adsorption surface 421 according to one embodiment of the present invention. FIG. 6 is a view illustrating a portion of the tray 400 according to one embodiment of the present invention.

The tray 400 may serve to transfer the material W. The tray 400 may transfer the material W while adsorbing the material W. The tray 400 may adsorb material W using the pressure difference ΔP. Specifically, the tray 400 may have the adsorption maintenance space 430 therein. More specifically, the tray 400 may include a tray body 410, a support 420, the adsorption maintenance space 430, the flow path entrance 440, a connection flow path 450, and an adsorption hole 460.

One end of the tray body 410 may be fixed to the transfer block 120. The adsorption maintenance space 430 to be described below may be formed inside the tray body 410.

The support 420 may lift and hold the material W. The support 420 may be provided on an upper end of the tray body 410. The support 420 may separate the material W from the tray body 410. A plurality of supports 420 may be disposed on the tray body 410. Referring to FIGS. 1 and 3, although two supports 420 are disposed in a direction (Y-axis) perpendicular to the process passage direction (X-axis) of the tray 400, this is merely one embodiment, and an arrangement shape of the supports 420 is not limited thereto.

The support 420 may be made of a rigid or elastic material. For example, the support 420 may be made of at least one material selected from a metal, a ceramic, a resin, and rubber. In one embodiment, the support 420 may be made of an elastic material. Accordingly, when one surface of the material W in contact with the adsorption surface 421 to be described below is patterned, a pattern may be prevented from being damaged by contact between the adsorption surface 421 and the material W.

The support 420 may include the adsorption surface 421. The adsorption surface 421 may be an upper surface of the support 420. The adsorption surface 421 may be in contact with one surface of the material W. The adsorption surface 421 may adsorb the material W.

The adsorption surface 421 may be flat and smooth without any protruding portions. Accordingly, an adsorption force of the adsorption surface 421 for the material W can be improved.

An area of the adsorption surface 421 may be smaller than an area of one surface of the material W in contact therewith. Specifically, referring to FIG. 5, a length 421D of one side of the adsorption surface 421 may be smaller than a length WD of one side of the material W corresponding thereto. Among a plurality of processes, there may be a process of coating one surface of the material W by spraying a coating liquid from above the material W. In this case, since the area of the adsorption surface 421 is smaller than that of one surface of the material W, the coating liquid is not sprayed on the adsorption surface 421, and thereby a phenomenon of the coating liquid contaminating one surface of the material W that comes into contact with the adsorption surface 421 when the tray 400 is reintroduced into the plurality of process sections P is prevented. In addition, since the coating liquid is not sprayed on the adsorption surface 421, the adsorption surface 421 can be maintained in a flat state while the adsorption hole 460 to be described below is prevented from being clogged. Accordingly, an adsorption force of the adsorption surface 421 for the material W can be maintained.

The adsorption maintenance space 430 may be an internal space of the tray 400 in which the pressure difference ΔP with the outside is formed such that the material W remains adsorbed onto the tray 400. Specifically, the adsorption maintenance space 430 may be formed inside the tray body 410. The adsorption maintenance space 430 may be formed below the support 420. The shape and volume of the adsorption maintenance space 430 are not particularly limited.

The adsorption maintenance space 430 may be a closed space except that the adsorption maintenance space 430 is connected to the connection flow path 450 and the adsorption hole 460 which will be described below. In other words, the adsorption maintenance space 430 may be in an airtight state except that the adsorption maintenance space 430 is connected to the connection flow path 450 and the adsorption hole 460.

The effect of the existence of the adsorption maintenance space 430 will be described below.

The flow path entrance 440 may serve as a fluid entrance through which a fluid is discharged from the adsorption maintenance space 430 or is discharged into the adsorption maintenance space 430. The flow path entrance 440 may be attached to or detached from the low pressure forming unit 200 and the pressure difference removing unit 300. When the flow path entrance 440 is coupled to the low pressure forming unit 200, a fluid may be discharged from the adsorption maintenance space 430 to the low pressure forming unit 200. When the flow path entrance 440 is coupled to the pressure difference removing unit 300, a fluid may be injected from the pressure difference removing unit 300 into the adsorption maintenance space 430.

On the other hand, the flow path entrance 440 may be closed when separated from the low pressure forming unit 200 and the pressure difference removing unit 300. Accordingly, when the tray 400 is separated from the low pressure forming unit 200 and the pressure difference removing unit 300 and passes through the process section P, air can be prevented from being suctioned into the adsorption maintenance space 430 through the flow path entrance 440.

In one embodiment, the flow path entrance 440 may include a check valve or a one-way valve.

Referring to FIG. 4, the flow path entrance 440 may be disposed at one side of the transfer block 120. Specifically, the flow path entrance 440 may be disposed in a direction opposite to a surface of the transfer block 120 to which the tray body 410 is fixed. Accordingly, the flow path entrance 440 may be smoothly attached to or detached from the low pressure forming unit 200 and the pressure difference removing unit 300 which are positioned in a direction opposite to a space in which the material W moves with respect to the guide block 110.

The connection flow path 450 may connect the adsorption maintenance space 430 and the flow path entrance 440. That is, through the connection flow path 450, the low pressure forming unit 200 and the pressure difference removing unit 300 may be connected to the adsorption maintenance space 430. The connection flow path 450 is illustrated as passing through the transfer block 120 in FIG. 4, but a specific path of the connection flow path 450 is not particularly limited. In one embodiment, the connection flow path 450 may include a pipe (not shown) that protrudes from the tray body 410 to be connected to the flow path entrance 440.

Referring to FIGS. 4 to 6, the adsorption hole 460 may be formed in the adsorption surface 421. The adsorption hole 460 may pass through the support 420. The adsorption hole 460 may be connected to the adsorption maintenance space 430. That is, the pressure of the adsorption hole 460 may be equal to the pressure of the adsorption maintenance space 430. Accordingly, the material W may be adsorbed onto the adsorption surface 421 by the pressure difference ΔP between the adsorption maintenance space 430 and the outside.

There may be at least one adsorption hole 460. In other words, a plurality of adsorption holes 460 may be included. An arrangement relationship of the plurality of adsorption holes 460 on the adsorption surface 421 is not particularly limited. In one embodiment, regarding the arrangement relationship of the plurality of adsorption holes 460 on the adsorption surface 421, as shown in FIGS. 5 and 6, one adsorption hole 460 may be disposed at a central portion, and one adsorption hole 460 may be disposed near each vertex of the support 420. However, this is merely an embodiment, and the arrangement relationship of the adsorption holes 460 on the adsorption surface 421 is not limited thereto.

A principle behind the material W being adsorbed onto the adsorption surface 421 is specifically as follows. When the material W comes into contact with the adsorption surface 421, the adsorption hole 460 is blocked from the outside by the material W. In this case, as a fluid present inside the adsorption maintenance space 430 is discharged by the low pressure forming unit 200, the pressure difference ΔP between the outside and the adsorption maintenance space 430 may be generated. Specifically, the outside is a space in a process which is separated from the adsorption maintenance space 430 by the tray body 410. The external pressure may be equal to the pressure of the process section P. When a fluid is discharged from the adsorption maintenance space 430 by the low pressure forming unit 200, the pressure of the adsorption maintenance space 430 may become lower than the external pressure. That is, the pressure difference ΔP may be generated, which may become a driving force with which the material W is adsorbed onto the adsorption surface 421.

The effect of the existence of the adsorption maintenance space 430 is as follows.

After being connected to the low pressure forming unit 200 before entering the plurality of process sections P, the tray 400 may remain separated from the low pressure forming unit 200 while passing through the plurality of process sections P. Meanwhile, it is realistically difficult to completely maintain airtightness. Therefore, unless the low pressure forming unit 200 is continuously connected to adsorb the material W, it is difficult to maintain an adsorption force of the adsorption surface 421 for the material W.

To compensate for this, the adsorption maintenance space 430 may be disposed between the low pressure forming unit 200 and the adsorption hole 460. By making a low-pressure state in the interior of the adsorption maintenance space 430 which has a relatively larger volume than the adsorption hole 460, a time for an adsorption force of the adsorption surface 421 for the material W to decrease may be delayed (buffered). Accordingly, the material W may remain adsorbed onto the adsorption surface 421 while the tray 400 passes through the process section P.

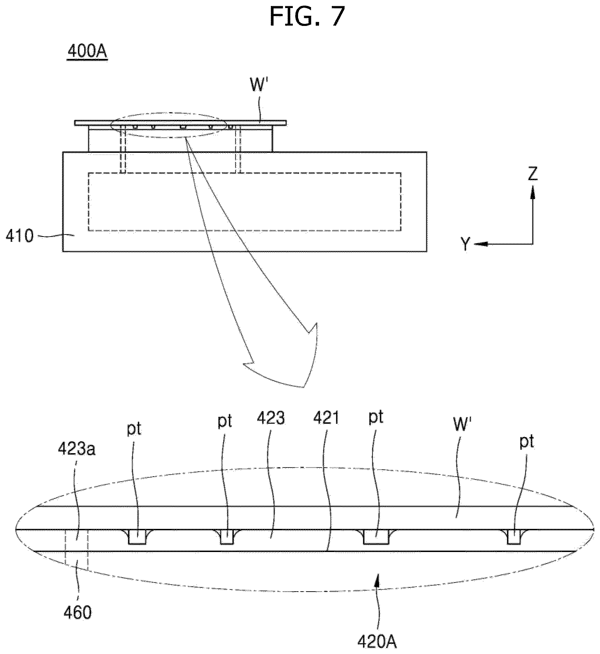

FIG. 7 is a view illustrating a tray 400a including an adsorption auxiliary member 423 according to one embodiment of the present invention.

The tray 400a may include a tray body 410, a support 420A, an adsorption maintenance space 430, a flow path entrance 440, a connection flow path 450, and an adsorption hole 460. Among these, since the tray body 410, the adsorption maintenance space 430, the flow path entrance 440, the connection flow path 450, and the adsorption hole 460 are identical or similar to those described for the tray 400, detailed descriptions will be omitted, and the differences will be mainly described. All components identical to those of the tray 400 shown in FIGS. 1 to 6 are assigned the same reference symbols in FIG. 7.

Referring to FIG. 7, the support 420A may further include the adsorption auxiliary member 423. The adsorption auxiliary member 423 may be disposed as one layer on an adsorption surface 421. The adsorption auxiliary member 423 may be made of a material having a higher elastic strain than the support 420A. The adsorption auxiliary member 423 may include a soft material. In one embodiment, the adsorption auxiliary member 423 may include rubber or silicone.

The adsorption auxiliary member 423 may include a second adsorption hole 423a. The second adsorption hole 423a may communicate with the adsorption hole 460 formed in the adsorption surface 421 of the support 420A. For this purpose, the second adsorption hole 423a may be formed in an area corresponding to the adsorption hole 460. For example, the second adsorption hole 423a may be formed in an area overlapping the adsorption hole 460 in a Z-axis direction. In addition, the number of second adsorption holes 423a may correspond to the number of adsorption holes 460. In addition, the second adsorption hole 423a may be provided to have a size corresponding to the adsorption hole 460.

Protrusions pt are patterned on one surface of a material W' in contact with the adsorption surface 421. The adsorption auxiliary member 423 may be disposed between the material W' and the adsorption surface 421, and thus, as shown in FIG. 7, the adsorption auxiliary member 423 may fill a gap between the material W' and the adsorption surface 421 which is generated by the protrusion pt. Thus, a close contact state between the material W' and the adsorption surface 421 may be maintained to maintain an adsorption force of the adsorption surface 421 for the material W'.

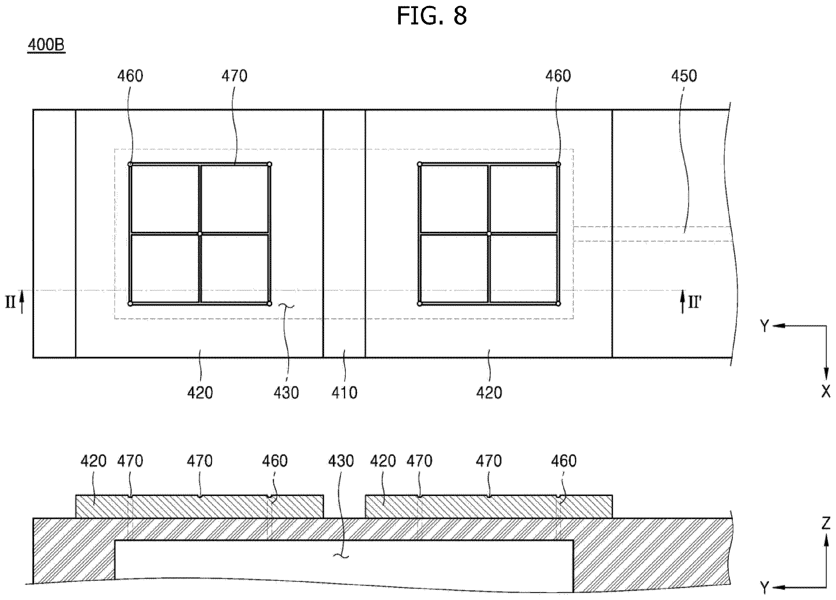

FIG. 8 shows a view illustrating a portion of a tray 400B and a cross-sectional view along line II-II' according to another embodiment of the present invention.

The tray 400B may include a tray body 410, a support 420, an adsorption maintenance space 430, a flow path entrance 440, a connection flow path 450, an adsorption hole 460, and an adsorption groove 470. Among these, since the tray body 410, the support 420, the adsorption maintenance space 430, the flow path entrance 440, the connection flow path 450, and the adsorption hole 460 are identical or similar to those described for the tray 400, detailed descriptions will be omitted, and the differences will be mainly described. All components identical to those of the tray 400 shown in FIGS. 1 to 6 are assigned the same reference symbols in FIG. 8.

Referring to FIG. 8, the adsorption groove 470 may be formed in an adsorption surface 421. The adsorption groove 470 may extend from the adsorption hole 460. That is, the adsorption groove 470 may be in the same pressure state as the adsorption maintenance space 430 when a material W is adsorbed onto the adsorption surface 421.

The adsorption groove 470 may generate a pressure difference ΔP to expand an adsorption area for adsorbing the material W. Specifically, since the adsorption groove 470 is present, the adsorption area for adsorbing the material W may be further increased from the sum of cross-sectional areas of the adsorption holes 460 to the sum of cross-sectional areas of the adsorption grooves 470. Accordingly, an upper limit of the pressure difference ΔP that may be formed by a low pressure forming unit 200 is increased, thereby improving an adsorption force of the adsorption surface 421 for the material W. In addition, even when a time for the material W to pass through a process section P becomes longer, a state in which the material W is adsorbed onto the adsorption surface 421 can be maintained.

A shape of the adsorption groove 470 is not particularly limited. As an example, as shown in FIG. 8, the adsorption groove 470 may have a shape that connects a plurality of adsorption holes 460 to each other. However, the adsorption groove 470 may be spaced apart from an edge of the support 420. Accordingly, the adsorption maintenance space 430 may be connected to the outside, thereby preventing an external fluid from being suctioned.

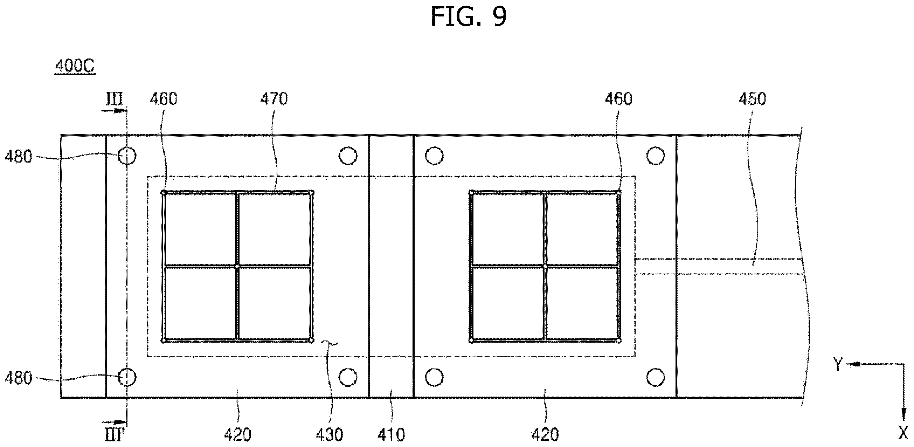

FIG. 9 is a view illustrating a portion of a tray 400C according to still another embodiment of the present invention. FIG. 10 shows views illustrating a process of separating a material W from the tray 400C in sequence through a cross section of the tray 400C along line III-III' of FIG. 9.

The tray 400C may include a tray body 410, a support 420, an adsorption maintenance space 430, a flow path entrance 440, a connection flow path 450, an adsorption hole 460, an adsorption groove 470, and a through-hole 480. However, the adsorption groove 470 may be omitted. Since the tray body 410, the support 420, the adsorption maintenance space 430, the flow path entrance 440, the connection flow path 450, the adsorption hole 460, and the adsorption groove 470 are identical or similar to those described for the trays 400 and 400B, detailed descriptions will be omitted, and the differences will be mainly described. All components identical to those of the tray 400 shown in FIGS. 1 to 8 are assigned the same reference symbols in FIGS. 9 and 10.

A plurality of lift pins LP for lifting the material W may pass through the through-holes 480. Referring to FIG. 9, a plurality of through-holes 480 may be formed. The through-holes 480 may be formed in the support 420. Referring to FIG. 10, the through-holes 480 may pass through both the tray body 410 and the support 420. Accordingly, the lift pin LP may protrude above the support 420 to lift the material W.

A process in which the material W is lifted by the lift pin LP will now be briefly described. Referring to FIG. 10A, the lift pin LP may pass through the through-holes 480 of the tray 400C, which has passed through all of a plurality of process sections P, to be lifted in a Z-axis direction. Referring to FIG. 10B, the lift pin LP may be continuously lifted to lift the material W. Referring to FIG. 10A, the lifted material W may be transferred to a subsequent process.

Referring to FIGS. 9 and 10, the through-holes 480 may be spaced apart from the adsorption maintenance space 430. As described above, since the through-hole 480 passes through the tray body 410, an arrangement relationship with the adsorption maintenance space 430 may be problematic. That is, since the through-holes 480 are positioned apart from the adsorption maintenance space 430, the airtightness of the adsorption maintenance space 430 can be maintained.

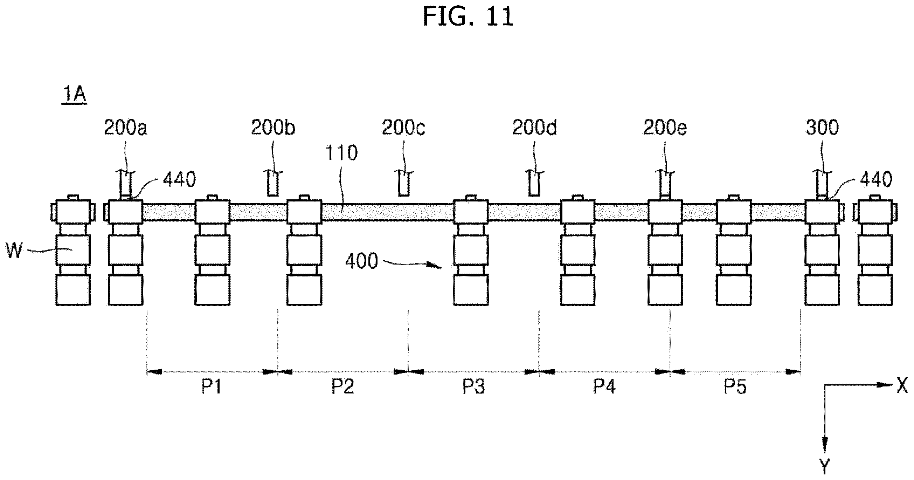

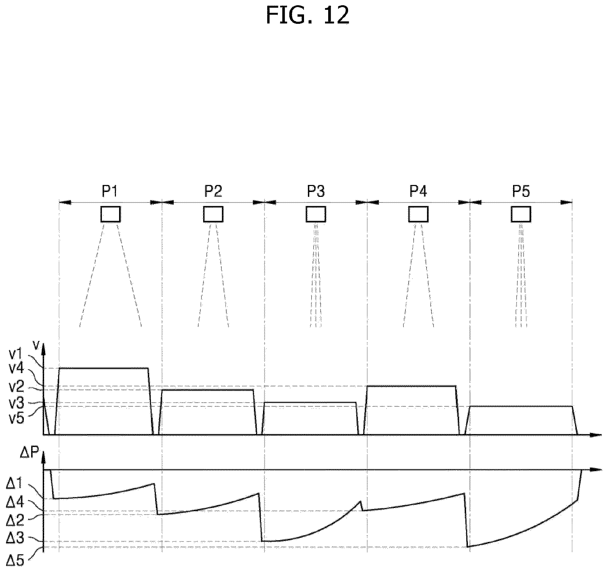

FIG. 11 is a plan view illustrating a substrate processing apparatus 1A according to another embodiment of the present invention. FIG. 12 is a diagram illustrating a movement speed v and a pressure difference ΔP according to a position of a material W in the substrate processing apparatus 1A according to another embodiment of the present invention.

The substrate processing apparatus 1A may include a driving unit 100, a low pressure forming unit 200, a pressure difference removing unit 300, and a tray 400. Since the driving unit 100, the pressure difference removing unit 300, and the tray 400 are identical or similar to those described for the substrate processing apparatus 1 described above, detailed descriptions will be omitted, and the differences will be mainly described. All components identical to those of the substrate processing apparatus 1 shown in FIGS. 1 to 10 are assigned the same reference symbols in FIGS. 11 and 12.

The low pressure forming unit 200 may include a plurality of low pressure forming units. Accordingly, the adsorption maintenance space 430 may be connected to the low pressure forming units 200 a plurality of times while passing through a plurality of process sections P, thereby repeatedly discharging a fluid from the inside of the adsorption maintenance space 430. That is, by repeatedly generating a low-pressure state inside the adsorption maintenance space 430, an adsorption force of the adsorption surface 421 for the material W can be strengthened such that the material W remains adsorbed onto an adsorption surface 421 while the tray 400 passes through the process section P.

In one embodiment, the low pressure forming unit 200 may include a number of low pressure forming units corresponding to a number of process sections P included in the plurality of process sections P. For example, as shown in FIG. 11, when the plurality of process sections P include a first process section P1, a second process section P2, a third process section P3, a fourth process section P4, and a fifth process section P5, the low pressure forming unit 200 may include a first low pressure forming unit 200a, a second low pressure forming unit 200b, a third low pressure forming unit 200c, a fourth low pressure forming unit 200d, and a fifth low pressure forming unit 200e. However, the present invention is not limited thereto. In another embodiment, the low pressure forming unit 200 may include a number of low pressure forming unit that are smaller than a number of process sections P included in the plurality of process sections P.

Each of a plurality of low pressure forming units 200 may be disposed at a position before the tray 400 enters one of the plurality of process sections P. The tray 400 may have a movement speed v of 0 for a moment while connected to the low pressure forming unit 200. That is, since the low pressure forming unit 200 is disposed at a position before the tray 400 enters each of the plurality of process sections P, the tray 400 may move without stopping within the plurality of process sections P so that each process may proceed smoothly.

For example, as shown in FIG. 11, the first low pressure forming unit 200a may be disposed at a position before the tray 400 enters the first process section P1. The second low pressure forming unit 200b may be disposed at a position before the tray 400 enters the second process section P2. The third low pressure forming unit 200c may be disposed at a position before the tray 400 enters the third process section P3. The fourth low pressure forming unit 200d may be disposed at a position before the tray 400 enters the fourth process section P4. The fifth low pressure forming unit 200e may be disposed at a position before the tray 400 enters the fifth process section P5.

In another embodiment, when the low pressure forming unit 200 includes a number of low pressure forming units that are smaller than a number of process sections P included in the plurality of process sections P, each of the low pressure forming units 200 may be positioned at a position before the tray 400 enters one of some of the plurality of process sections P. In this case, an arrangement position of the low pressure forming unit 200 may be determined according to the process characteristics of the plurality of process sections P.

Pressure differences ΔP formed by some or all of the plurality of low pressure forming units 200 may be different. Specifically, the pressure difference ΔP has a value obtained by subtracting an external pressure from a pressure inside the adsorption maintenance space 430. Referring to FIG. 12, the pressure difference ΔP may be less than 0. However, when sizes of the pressure differences ΔP are compared in the present specification, absolute values of the pressure differences ΔP are compared. Hereinafter, the same applies in the specification.

For example, referring to FIGS. 11 and 12, the first low pressure forming unit 200a disposed before the tray 400 enters the first process section P1 may form a first pressure difference Δ1 in the adsorption maintenance space 430. The second low pressure forming unit 200b disposed before the tray 400 enters the second process section P2 may form a second pressure difference Δ2 in the adsorption maintenance space 430. The third low pressure forming unit 200c disposed before the tray 400 enters the third process section P3 may form a third pressure difference Δ3 in the adsorption maintenance space 430. The fourth low pressure forming unit 200d disposed before the tray 400 enters the fourth process section P4 may form a fourth pressure difference Δ4 in the adsorption maintenance space 430. The fifth low pressure forming unit 200e disposed before the tray 400 enters the fifth process section P5 may form a fifth pressure difference Δ5 in the adsorption maintenance space 430.

An example of the more specific characteristics of the process section P will now be described. However, the following description is merely an example for describing the features of the substrate processing apparatus 1A and is not limiting. In other words, the substrate processing apparatus 1A is not limited to the following cases and may be applied to all cases in which the plurality of process sections P are continuous.

As an example, the substrate processing apparatus 1 or 1A may be used for manufacturing a perovskite solar cell or a tandem solar cell including perovskite. More specifically, the substrate processing apparatus 1 or 1A can be used for manufacturing a tandem solar cell.

A tandem solar cell may include a recombination layer, a hole transfer layer, and a perovskite light-absorbing layer which are disposed on a first solar cell.

The first solar cell may include any one of various solar cells such as a crystalline silicon (Si) solar cell, a polycrystalline silicon solar cell, a copper indium gallium selenide (CIGS)-based solar cell, a perovskite solar cell, a gallium arsenide (GaAs) solar cell, a dye sensitized solar cell, an organic solar cell, and a compound solar cell.

The recombination layer may be a layer that induces recombination of electrons and holes generated in at least one of the first solar cell and the perovskite light-absorbing layer.

The hole transfer layer may be a layer that transfers holes formed in the perovskite light-absorbing layer and blocks the movement of electrons.

The perovskite light-absorbing layer is a layer that absorbs light and may include a perovskite material.

In addition, the tandem solar cell may further include a protective layer. The protective layer may be disposed between the electron transfer layer and the perovskite light-absorbing layer. The protective layer may facilitate the transfer of holes and may prevent a phenomenon in which generated charges recombine with each other.

For this purpose, the protective layer may include a material having a carbazole body with excellent hole transfer and collection power and a phosphonic acid group with excellent bonding power with a metal oxide. Specifically, the protective layer may include a self-assembled monolayer (SAM) material. As an example, the protective layer may include a SAM material such as 2-PACz, MeO-2PACz, Br-2PACz, Me4PACz, MeO-4PACz, or 6-PACz.

As a specific embodiment, the substrate processing apparatus 1 or 1A may form the protective layer.

The first process section P1 may correspond to a plasma treatment process. The first process section P1 may correspond to a treatment process using atmospheric pressure plasma. In the first process section P1, the material W may be treated with plasma before being coated with a SAM material. A movement speed v of the tray required in the first process section P1 may be a first movement speed v1.

The process of the second process section P2 may be performed after that of the first process section P1. The second process section P2 may correspond to a rinse process. The process of the second process section P2 may be performed in a spray manner. The movement speed v of the tray required in the second process section P2 may be a second movement speed v2.

The process of the third process section P3 may be performed after that of the second process section P2. The third process section P3 may correspond to a first drying process. The third process section P3 may correspond to an air-blowing drying process. The movement speed v of the tray required in the third process section P3 may be a third movement speed v3.

The process of the fourth process section P4 may be performed after that of the third process section P3. The fourth process section P4 may correspond to a coating process. The fourth process section P4 may correspond to a spray coating process. In the fourth process section P4, a SAM material may be sprayed onto the material W. In the fourth process section P4, the material W may be coated with the SAM material. As an example, a material sprayed in the fourth process section P4 may include a SAM material such as 2-PACz, MeO-2PACz, Br-2PACz, Me4PACz, MeO-4PACz, or 6-PACz. The movement speed v of the tray required in the fourth process section P4 may be a fourth movement speed v4.

The process of the fifth process section P5 may be performed after that of the fourth process section P4. The fifth process section P5 may correspond to a second drying process. The fifth process section P5 may correspond to an air-blowing drying process. In the fifth process section P5, the SAM material sprayed onto the material W may be dried. The movement speed v of the tray required in the fifth process section P5 may be a fifth movement speed v5.

Widths of the first to fifth process sections P1 to P5 are assumed to all be the same. Since the first movement speed v1 required in the first process section P1 is faster than the second to fifth movement speeds v2, v3, v4, and v5 required in the other process sections, a time for the tray 400 to stay in the first process section P1 may be shorter than that in the other process sections. Taking this into account, the first pressure difference Δ1 formed by the first low pressure forming unit 200a disposed before the tray 400 enters the first process section P1 may be smaller than the second to fifth pressure differences Δ2, Δ3, Δ4, and Δ5 formed by the low pressure forming units 200 disposed before the tray 400 enters the other process sections.

The second movement speed v2 required in the second process section P2 may be slower than the first movement speed v1 required in the first process section P1. Thus, a time for the tray 400 to stay in the second process section P2 may be longer than that in the first process section P1. Taking this into account, the second pressure difference Δ2 formed by the second low pressure forming unit 200b disposed before the tray 400 enters the second process section P2 may be greater than the first pressure difference Δ1 formed by the first low pressure forming unit 200a disposed before the tray 400 enters the first process section P1.

The third movement speed v3 required in the third process section P3 may be slower than the second movement speed v2 required in the second process section P2. Thus, a time for the tray 400 to stay in the third process section P3 may be longer than that in the second process section P2. Taking this into account, the third pressure difference Δ3 formed by the third low pressure forming unit 200c disposed before the tray 400 enters the third process section P3 may be greater than the second pressure difference Δ2 formed by the second low pressure forming unit 200b disposed before the tray 400 enters the second process section P2.

The fourth movement speed v4 required in the fourth process section P4 may be faster than the third movement speed v3 required in the third process section P3. Thus, a time for the tray 400 to stay in the fourth process section P4 may be shorter than that in the third process section P3. Taking this into account, the fourth pressure difference Δ4 formed by the fourth low pressure forming unit 200d positioned before the tray 400 enters the fourth process section P4 may be smaller than the third pressure difference Δ3 formed by the third low pressure forming unit 200c disposed before the tray 400 enters the third process section P3.

In one embodiment, a time for the tray 400 to stay in the fourth process section P4 may be shorter than or equal to the time for the tray 400 to stay in the second process section P2. For this purpose, the fourth movement speed v4 may be faster than or equal to the second movement speed v2. In addition, the fourth pressure difference Δ4 may be smaller than or equal to the second pressure difference Δ2. In one embodiment, the time for the tray 400 to stay in the fourth process section P4 may be equal to the time for the tray 400 to stay in the second process section P2 so that the fourth movement speed v4 may be equal to the second movement speed v2, and the fourth pressure difference Δ4 may be equal to the second pressure difference Δ2.

The fifth movement speed v5 required in the fifth process section P5 may be slower than the fourth movement speed v4 required in the fourth process section P4. Thus, a time for the tray 400 to stay in the fifth process section P5 may be longer than that in the fourth process section P4. Taking this into account, the fifth pressure difference Δ5 formed by the fifth low pressure forming unit 200e disposed before the tray 400 enters the fifth process section P5 may be greater than the fourth pressure difference Δ4 formed by the fourth low pressure forming unit 200d disposed before the tray 400 enters the fourth process section P4.

In one embodiment, the time for the tray 400 to stay in the fifth process section P5 may be longer than or equal to the time for the tray 400 to stay in the third process section P3. For example, in order to effectively dry the SAM material deposited on the material W in the fourth process section P4, a time for the tray 400 to stay in the fifth process section P5 may be longer than or equal to a time for the tray 400 to stay in the third process section P3. For this purpose, the fifth movement speed v5 may be slower than or equal to the third movement speed v3. In addition, the fifth pressure difference Δ5 may be greater than or equal to the third pressure difference Δ3. In one embodiment, the time for the tray 400 to stay in the fifth process section P5 may be equal to the time for the tray 400 to stay in the third process section P3 so that the fifth movement speed v5 may be equal to the third movement speed v3, and the fifth pressure difference Δ5 may be equal to the third pressure difference Δ3.

As can be seen from the specific example above, by making the pressure difference ΔP formed by the low pressure forming unit 200 disposed before the tray enters each process section P different for each process section P, an adsorption state of the material W passing through each process section P may be adjusted according to the characteristics of each process section P. Accordingly, a preset material may be applied and deposited on the material W through an in-line process, thereby enabling efficient process operation and contributing to an improvement in product productivity.

Since a driving unit provided in a substrate processing apparatus according to one embodiment of the present invention can control a speed for each process section, there is no need to secure a transfer distance for speed compensation for each process, a limited number of trays can be used repeatedly, and thereby a size of equipment can be reduced.

In a substrate processing apparatus according to one embodiment of the present invention, by making an area of an adsorption surface smaller than one surface of a material, unnecessary contamination of the material passing through a coating process can be prevented, and an adsorption force of the adsorption surface for the material can be simultaneously maintained.

In a substrate processing apparatus according to one embodiment of the present invention, an adsorption maintenance space may be formed to delay (buffer) a time for an adsorption force of an adsorption surface for a material to decrease, thereby maintaining a state in which the material is adsorbed onto the adsorption surface while a tray passes through a process section.

In a substrate processing apparatus according to one embodiment of the present invention, a pressure difference, which is formed by a low pressure forming unit, which is disposed before a tray enters each process section, is set differently for each process section, and thereby an adsorption state of a material passing through each process section is adjusted according to the characteristics of each process section. Therefore, it is possible to enable efficient process operation and contribute to an improvement in product productivity.

In a substrate processing apparatus according to one embodiment of the present invention, a preset material, for example, a SAM material, can be applied and deposited on a material through an in-line process, thereby improving process efficiency.

The effects of the present invention are not limited to the above-described effects, and other effects which are not described will be clearly understood by those skilled in the art from the following detailed description and the accompanying drawings.

The present invention has been described above with reference to embodiments shown in the drawings, but these are only examples. Those of ordinary skill in the art may fully understand that various modifications and other equivalent embodiments are possible from the embodiments. Therefore, the true technical protection scope of the present invention should be determined based on the appended claims.

Specific technical content described in the embodiments relates to embodiments and does not limit the technical scope of the embodiments. In order to concisely and clearly describe the invention, descriptions of conventional general techniques and configurations may be omitted. In addition, the connection or connection members of lines between the components shown in the drawings are illustrative of functional connections and/or physical or circuit connections and may be represented as a variety of functional connections, physical connections, or circuit connections that can be replaced or added in an actual device. In addition, when there is no specific mention such as "essential" or "importantly," a component may not be an essential component for the application of the present invention.

In the description of the invention and in the claims, "the" or similar referents may refer to both the singular and the plural unless otherwise specified. In addition, when a range is described in the embodiment, it includes the invention to which individual values within the range are applied (unless there is a description to the contrary), and each individual value constituting the range is described in the description of the invention. In addition, the operations constituting the method according to the embodiment may be performed in any appropriate order unless the order is explicitly stated or there is a description to the contrary. The embodiments are not necessarily limited by the described order of the operations. The use of all examples or illustrative terms (e.g., "and the like") in the embodiments is merely for the purpose of describing the embodiments in detail, and unless limited by the claims, the scope of the embodiments is not limited by the above examples or exemplary terms. In addition, those skilled in the art will appreciate that various modifications, combinations, and changes may be made in accordance with design conditions and factors within the scope of the appended claims or their equivalents.

## Claims

1. A substrate processing apparatus comprising:
a tray having an adsorption maintenance space formed therein;
a driving unit configured to allow the tray to successively pass through a plurality of process sections;
a low pressure forming unit positioned at one side of the driving unit at a position before the tray enters the plurality of process sections and configured to discharge a fluid from the adsorption maintenance space to form a pressure difference between the adsorption maintenance space and an outside; and
a pressure difference removing unit disposed at one side of the driving unit at a position at which all of the plurality of process sections end and configured to inject a fluid into the adsorption maintenance space,
wherein the tray adsorbs a material using the pressure difference.

2. The substrate processing apparatus as claimed in claim 1, wherein the material moves through each of the plurality of process sections for a movement time set for each of the plurality of process sections, and
the movement times are all different or some are equal among the plurality of process sections.

3. The substrate processing apparatus as claimed in claim 2, wherein a movement speed at which the driving unit moves the tray is different for each of the plurality of process sections.

4. The substrate processing apparatus as claimed in claim 1, wherein the tray further includes a support on which the material is placed,
the support includes an adsorption surface which is in in contact with one surface of the material to adsorb the material, and
an area of the adsorption surface is smaller than that of the one surface of the material with which the adsorption surface is in contact.

5. The substrate processing apparatus as claimed in claim 4, wherein the tray further includes:
at least one adsorption hole formed in the adsorption surface and connected to the adsorption maintenance space;
a flow path entrance that closes when separated from the low pressure forming unit and the pressure difference removing unit; and
a connection flow path configured to connect the adsorption maintenance space and the flow path entrance.

6. The substrate processing apparatus as claimed in claim 5, wherein the tray further includes an adsorption groove formed in the adsorption surface and extending from the adsorption hole.

7. The substrate processing apparatus as claimed in claim 5, wherein the support further includes an adsorption auxiliary member, and
the adsorption auxiliary member includes a second adsorption hole which is formed in an area corresponding to the adsorption hole and communicates with the adsorption hole.

8. The substrate processing apparatus as claimed in claim 1, wherein the tray further includes a plurality of through-holes through which a plurality of lift pins configured to lift the material pass, and
the through-holes are spaced apart from the adsorption maintenance space.

9. The substrate processing apparatus as claimed in claim 1, wherein the low pressure forming unit includes a plurality of low pressure forming units, and
each of the plurality of low pressure forming units is positioned at a position before the tray enters one of the plurality of process sections.

10. The substrate processing apparatus as claimed in claim 9, wherein the pressure difference formed by some or all of the plurality of low-pressure forming units are different.

11. The substrate processing apparatus as claimed in claim 2, wherein the plurality of process sections include:
a first process section in which a plasma treatment process is performed on the material;
a second process section in which a rinse process is performed on the material;
a third process section in which a first drying process is performed on the material;
a fourth process section in which a coating process is performed on the material; and
a fifth process section in which a second drying process is performed on the material,
wherein the coating process includes a process of coating the material with a self-assembled monolayer (SAM) material.
